# EUROPEAN PATENT APPLICATION

(11) **EP 4 701 369 A2**
(43) Date of publication of application: **25.02.2026**
(21) Application number: 26150418.7
(22) Date of filing: 06.01.2026
(51) Int. Cl.: H10F 10/166, H10F 77/20

(54) **SOLAR CELL AND PHOTOVOLTAIC MODULE**

(30) Priority: 28.03.2025 CN 202510397859
(71) Applicant: Zhejiang Jinko Solar Co., Ltd., Haining, Zhejiang 314416 (CN)
(72) Inventor: LIU, Zhaoxuan, Haining, 314416 (CN); ZHANG, Bo, Haining, 314416 (CN); ZHANG, Bike, Haining, 314416 (CN); JIN, Jingsheng, Haining, 314416 (CN); CHEN, Yuqian, Haining, 314416 (CN)
(74) Representative: Haseltine Lake Kempner LLP

(57) **Abstract**

A solar cell includes a substrate including a front surface and a back surface, the back surface provided with a first protruding portion, a second protruding portion, and a recessed portion located between the first protruding portion and the second protruding portion that are arranged alternately; a plurality of first doped layers arranged at intervals and covering a surface of the first protruding portion away from the front surface, and the first doped layer protruding beyond a sidewall of the first protruding portion; a plurality of second doped layers arranged at intervals and covering a bottom surface of the second protruding portion; a third doped layer covering at least the sidewall of the first protruding portion, the third doped layer being in contact with a portion of the first doped layer protruding beyond the sidewall of the first protruding portion; a first electrode; and a second electrode.

## Description

### TECHNICAL FIELD

The present application relates to the field of photovoltaics, and in particular to a solar cell and a manufacturing method thereof, and a photovoltaic module.

### BACKGROUND

Conversion efficiency of crystalline silicon solar cells has continuously increased through technological iterations, developing from BSF and PERC to PERC+. Currently, mass-production efficiency of PERC+ can be about 23.45%, which is close to a theoretical limit efficiency of 24.5%. There is difficult to further improve efficiency, with limited improvement. Currently, tunnel oxide passivated contact (TOPCon) solar cells, heterojunction (HJT) solar cells, and back contact solar cells have emerged as new development trends for the crystalline silicon solar cells, representing current frontiers of international research and industrialization.

The back contact solar cell is a crystalline silicon solar cell in which both an emitter electrode and a base electrode of the solar cell are located on the back surface of the solar cell. There is no metal grid electrode to shade the front surface, the back contact solar cell exhibits enhanced light absorption efficiency, thereby greatly increasing short-circuit current. Moreover, the back contact solar cell adopts amorphous silicon, or microcrystalline silicon, or their doping forms to passivate the surface of the solar cell, thereby increasing an open-circuit voltage. The above factors effectively enhance conversion efficiency of the back contact solar cell, so that the back contact solar cell has good development prospects.

### SUMMARY

According to some embodiments of the present application, in an aspect, an embodiment of the present application provides a solar cell, including: a substrate including a front surface and a back surface opposite to each other, the back surface provided with a first protruding portion, a second protruding portion, and a recessed portion located between the first protruding portion and the second protruding portion that are arranged alternately; a plurality of first doped layers arranged at intervals, the first doped layer covering a surface of the first protruding portion away from the front surface, the first doped layer protruding beyond a sidewall of the first protruding portion, and the first doped layer doped with an element of a first doping type; a plurality of second doped layers arranged at intervals, the second doped layer covering a bottom surface of the second protruding portion, and the second doped layer doped with an element of a second doping type; a third doped layer, the third doped layer covering at least the sidewall of the first protruding portion, the third doped layer being in contact with a portion of the first doped layer protruding beyond the sidewall of the first protruding portion, the third doped layer doped with an element of the second doping type, the element of the first doping type being either of N-type element and P-type element, and the element of the second doping type being another of the N-type element and the P-type element; a first electrode electrically connected to the first doped layer; and a second electrode electrically connected to the second doped layer.

In some embodiments, the recessed portion includes a flat region, a transition region, and a textured region; the flat region is adjacent to the first protruding portion, and the third doped layer further covers a surface of the flat region; the transition region is located on a side of the flat region away from the first protruding portion; and the textured region is located on a side of the transition region away from the flat region, and the textured region has a morphology of a pyramid structure.

In some embodiments, the third doped layer leaves the transition region exposed.

In some embodiments, a height of the transition region ranges from 0.5 µm to 3 µm, and an inclination angle of the transition region ranges from 30° to 60°.

In some embodiments, a concentration of doping elements in the third doped layer is the same as a concentration of doping elements in the second doped layer.

In some embodiments, the first doped layer is disposed to protrude beyond two sides of the first protruding portion, and the third doped layer covers the two sidewalls of the first protruding portion opposite to each other.

In some embodiments, the solar cell further includes a fourth doped layer, wherein the fourth doped layer covers a sidewall of the second protruding portion and a portion of a surface of the recessed portion, the fourth doped layer is in contact with and electrically connected to the second doped layer, and the fourth doped layer is doped with an element of the first doping type.

In some embodiments, the third doped layer covers a sidewall of the first protruding portion along a first direction, and the second doped layer is in contact with a sidewall of the first doped layer along a second direction.

In some embodiments, the first doped layer is disposed to protrude beyond the sidewall of the first protruding portion by a distance ranging from 0.1 µm to 3 µm.

In some embodiments, a width of a contact interface between the third doped layer and the first doped layer ranges from 0.1 µm to 2 µm.

In some embodiments, another embodiment of the present application further provides a manufacturing method for a photovoltaic module, including:
providing an initial substrate, the initial substrate including a front surface and a back surface opposite to each other;
forming an initial first doped layer, the initial first doped layer covering the back surface of the initial substrate;
performing an alkaline polishing process, the alkaline polishing process etching the initial first doped layer and the initial substrate to form a first protruding portion, a second protruding portion, and a recessed portion located between the first protruding portion and the second protruding portion that are arranged alternately on the back surface, with the remaining initial substrate as a substrate, and forming a plurality of first doped layers arranged at intervals, the first doped layer covering a surface of the first protruding portion away from the front surface, the first doped layer protruding beyond a sidewall of the first protruding portion, and the first doped layer doped with an element of a first doping type;
forming a plurality of second doped layers arranged at intervals, the second doped layer covering a bottom surface of the second protruding portion, and the second doped layer doped with an element of a second doping type;
forming a third doped layer, the third doped layer covering at least the sidewall of the first protruding portion, the third doped layer being in contact with a portion of the first doped layer protruding beyond the sidewall of the first protruding portion, the third doped layer doped with an element of the second doping type, the element of the first doping type being either of N-type element and P-type element, and the element of the second doping type being another of the N-type element and the P-type element;
forming a first electrode electrically connected to the first doped layer; and
forming a second electrode electrically connected to the second doped layer.

In some embodiments, the alkaline polishing process includes laser treatment by irradiating a surface of the initial first doped layer; and a wet etching process, including removing the initial first doped layer that has undergone the laser treatment, and etching a portion of the initial substrate to form the first doped layer and the substrate.

In some embodiments, process parameters of the laser treatment include a laser type of an infrared light source, a green light source, or an ultraviolet light source, laser energy ranging from 50 W to 150 W, a scan speed ranging from 10 m/s to 100 m/s, and a frequency ranging from 500 kHz to 1500 kHz.

In some embodiments, a method for forming the third doped layer includes forming an initial third doped layer, the initial third doped layer covering the first doped layer and a back surface of the substrate; and performing laser processing, the laser processing including removing a portion of the initial third doped layer along a direction from the back surface towards the front surface, with the remaining initial third doped layer located on the sidewall of the first protruding portion as the third doped layer.

According to some embodiments of the present application, in yet another aspect, an embodiment of the present application further provides a photovoltaic module, including: a solar cell string including a plurality of solar cells as described above or a plurality of solar cells manufactured with the method as described above; a solder strip electrically connected to at least two of the solar cells to connect adjacent solar cells in series; an encapsulation adhesive film configured to cover a surface of the solar cell string; and a cover plate configured to cover a surface of the encapsulation adhesive film away from the solar cell string.

### BRIEF DESCRIPTION OF THE DRAWINGS

One or more embodiments are exemplarily described by using figures that are corresponding thereto in the accompanying drawings; the exemplary descriptions do not constitute limitations on the embodiments. Unless otherwise particularly stated, the figures in the accompanying drawings do not constitute a scale limitation. In order to more clearly illustrate the technical solutions in embodiments of the present application or the conventional art, the accompanying drawings used in the description of the embodiments or the conventional art will be briefly introduced below. It is apparent that, the accompanying drawings in the following description are only some embodiments of the present application, and other drawings can be obtained by those of ordinary skill in the art from the provided drawings without creative efforts.
FIG. 1 is a cross-sectional view of a solar cell according to an embodiment of the present application.
FIG. 2 is a top view of the solar cell according to an embodiment of the present application.
FIG. 3 to FIG. 5 are schematic structural views corresponding to steps of a manufacturing method for a solar cell according to an embodiment of the present application.
FIG. 6 is a schematic structural view of a photovoltaic module according to an embodiment of the present application.
FIG. 7 is a cross-sectional view of the photovoltaic module according to an embodiment of the present application.

### DETAILED DESCRIPTION

As can be seen from the background, currently, when a solar cell is partially shaded or the solar cell malfunctions, the solar cell is prone to generate a hot spot phenomenon. The hot spot phenomenon refers to a phenomenon in which a temperature in certain regions of a solar cell or a photovoltaic module is significantly higher than the temperature in other regions due to local overheating. This phenomenon is generally caused by uneven current distribution or excessively high local resistance, which can seriously affect performance and service life of the solar cell. Therefore, there is a need to mitigate the hot spot phenomenon in the solar cell.

Embodiments of the present application provide a solar cell. A first doped layer is disposed to protrude beyond a sidewall of a first protruding portion, and the protruding part of the first doped layer is taken as a contact window to be contact with a third doped layer, thereby forming a current leakage path between the first doped layer and the third doped layer. When the solar cell is partially shaded or the solar cell malfunctions to cause abnormal local heating, the current leakage path can shunt the electric current, thereby mitigating influences of the hot spot phenomenon. Besides, the first doped layer is disposed to protrude beyond the sidewall of the first protruding portion, which can protect the third doped layer located below the first doped layer, thereby facilitating retaining of the third doped layer located below the first doped layer to establish a good current leakage path. Moreover, during the formation of the third doped layer, since the first doped layer is disposed to protrude beyond the sidewall of the first protruding portion, the surface of the third doped layer can be protected from erosion by an etching reagent, so as to establish a relatively complete current leakage channel on the back surface of the solar cell. The complete current leakage channel can provide a uniform transport path for charge carriers, which prevents concentration of the current in certain regions, reduces increase of local resistance, and reduces heat accumulation. The uniform current distribution reduces the risk of hot spots caused by excessive local current.

The technical terms "first" and "second" mentioned in the description of the embodiments of the present application are merely used for distinguishing different objects, and cannot be construed as indicating or implying a relative importance, or implicitly specifying the number, specific order or primary-secondary relationship of the indicated technical features. In the description of the embodiments of the present application, "a plurality of" means two or more, unless otherwise defined explicitly and specifically.

The term "embodiment" herein means that specific features, structures, or characteristics described with reference to the embodiment can be included in at least one embodiment of the present application. The term "embodiment" appeared in various places in the specification does not necessarily refer to the same embodiment or an independent or alternative embodiment that is mutually exclusive of other embodiments. It can be explicitly and implicitly understood by those skilled in the art that the embodiment described herein can be combined with other embodiments.

The term "and/or" in the description of the embodiments of the present application merely describes a relationship between associated objects, indicating that three types of relationships may exist. For example, A and/or B can indicate three situations: only A exists, both A and B exist, and only B exists. In addition, the character "/" herein generally represents that the former and latter associated objects are in an "or" relationship.

The term "multiple" in the description of the embodiments of the present application means two or more. Similarly, "multiple groups" means two or more groups, and "multiple pieces" means two or more pieces.

In the description of the embodiments of the present application, it should be understood that the terms "center", "longitudinal", "transverse", "length", "width", "thickness", "upper", "lower", "front", "back", "left", "right", "vertical", "horizontal", "top", "bottom", "inner", "outer", "clockwise", "counterclockwise", "axial", "radial", "circumferential" etc. indicate the orientations or positional relationships on the basis of the drawings. These terms are only for the convenience of describing the present application and simplifying the description, rather than indicating or implying that the related devices or element must have specific orientations, or be constructed or operated in the specific orientations, and therefore cannot be understood as limitations of the present application.

In the description of the embodiments of the present application, unless otherwise clearly specified and defined, the terms "installed", "connected", "coupled", "fixed" and the like should be understood broadly. For example, an element, when being referred to as being "installed", "connected", "coupled", or "fixed" to another element, unless otherwise specifically defined, may be fixedly connected, detachably connected, or integrated to the other element, may be mechanical connected or electrically connected to the other element, and may be directly connected to the other element or connected to the other element via an intermediate medium, or internal communication between two components or the interaction between two components.. For those skilled in the art, the specific meanings of the above terms in the present application can be understood according to specific circumstances.

In the drawings corresponding to the embodiments of the present application, for better understanding and ease of description, a thickness and an area of a layer are exaggerated. When a component (such as a layer, a film, a region, or a substrate) is described as on another component, the component can be "directly" on the surface of another component, or there can be a third component between the two components. In contrast, when one component is described as on a surface of another component, or one component is formed on or provided on the surface of another component, there is no third component between the two components. In addition, when one component is described as "substantially" formed on another component, it means that the component is neither formed on the entire surface (or a front surface) of another component, nor formed on a portion of an edge of the entire surface.

In the description of the embodiments of the present application, unless otherwise stated, when one component "includes" another component, other components are not excluded and can further be included therein. In addition, when a component such as a layer, a film, a region, or a plate is referred to as being "on" another component, it can be "directly on" the other component (i.e., on a surface of the other component without other components therebetween), or another component can exist therebetween. In addition, when a component such as a layer, a film, a region, or a plate is "directly on" another component, or when a component such as a layer, a film, a region, or a plate is on a surface of another component, it means that no other components exist therebetween.

The terms used in the description of the embodiments herein are for describing particular embodiments only and not intended to be limiting. As used in the description of various embodiments and the appended claims, "the component" is also intended to include the plural form, unless otherwise explicitly indicated in the context. The component includes a component such as a layer, a film, a region, or a plate.

Various embodiments of the present application will be described in detail with reference to the accompanying drawings. However, those of ordinary skill in the art can understand that many technical details are provided in the embodiments of the present application to enable readers to better understand the embodiments of the present application. However, even without these technical details and various changes and modifications based on the following embodiments, the technical solutions claimed in the embodiments of the present application can be implemented.

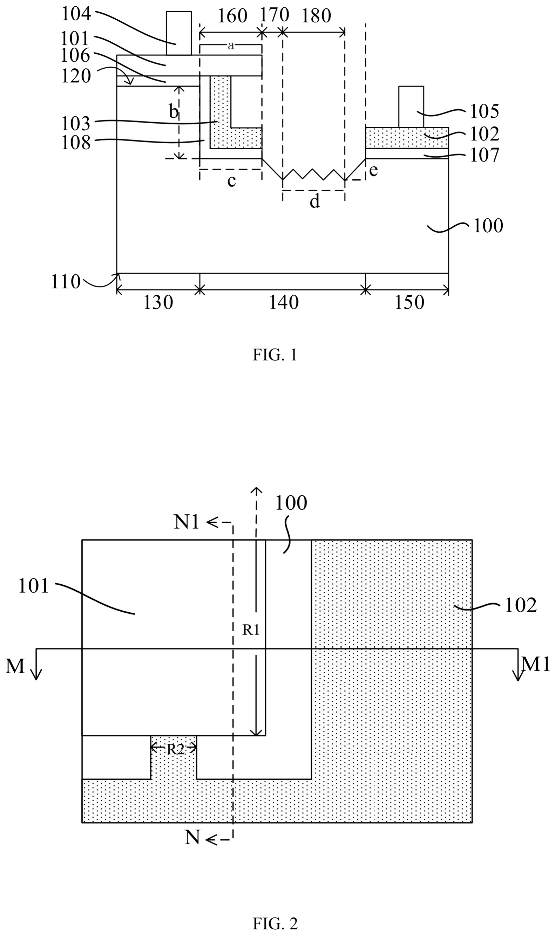

Referring to FIG. 1 and FIG. 2, FIG. 1 is a cross-sectional view of a solar cell according to an embodiment of the present application, FIG. 2 is a top view of the solar cell according to an embodiment of the present application, and FIG. 1 is a cross-sectional view of FIG. 2 taken along a direction MM1.

In some embodiments, the solar cell can include a substrate 100. The substrate 100 includes a front surface 110 and a back surface 120 opposite to each other. The back surface 120 is provided with a first protruding portion 130, a second protruding portion 150, and a recessed portion 140 located between the first protruding portion 130 and the second protruding portion 150 that are arranged alternately.

The solar cell further includes a plurality of first doped layers 101 arranged at intervals. The first doped layer 101 covers a surface of the first protruding portion 130 away from the front surface 110, and the first doped layer 101 protrudes beyond a sidewall of the first protruding portion 130. The first doped layer 101 is doped with an element of a first doping type.

The solar cell further includes a plurality of second doped layers 102 arranged at intervals. The second doped layer 102 covers a bottom surface of the second protruding portion 150, and the second doped layer 102 is doped with an element of a second doping type.

The solar cell further includes a third doped layer 103. The third doped layer 103 covers at least the sidewall of the first protruding portion 130, and the third doped layer 103 is in contact with a portion of the first doped layer 101 protruding beyond the sidewall of the first protruding portion 130. The third doped layer 103 is doped with an element of a second doping type. The element of the first doping type is either of N-type element and P-type element, and the element of the second doping type is the other of the N-type element and the P-type element.

The solar cell further includes a first electrode 104. The first electrode 104 is electrically connected to the first doped layer 101.

The solar cell further includes a second electrode 105. The second electrode 105 is electrically connected to the second doped layer 102.

Embodiments of the present application provide a solar cell. The first doped layer 101 is disposed to protrude beyond the sidewall of the first protruding portion 130, and the protruding part of the first doped layer 101 is taken as a contact window to be contact with the third doped layer 103, thereby forming a current leakage path between the first doped layer 101 and the third doped layer 103. When the solar cell is partially shaded or the solar cell malfunctions to cause abnormal local heating, the current leakage path can shunt the electric current, thereby mitigating influences of the hot spot phenomenon. Besides, the first doped layer 101 is disposed to protrude beyond the sidewall of the first protruding portion 130, which can protect the third doped layer 103 located below the first doped layer 101, thereby facilitating retaining of the third doped layer 103 located below the first doped layer 101 to establish a good current leakage path. Moreover, during the formation of the third doped layer 103, since the first doped layer 101 is disposed to protrude beyond the sidewall of the first protruding portion 130, the surface of the third doped layer 103 can be protected from erosion by an etching reagent, so as to establish a relatively complete current leakage channel on the back surface 120 of the solar cell. The complete current leakage channel can provide a uniform transport path for charge carriers, which prevents concentration of the current in certain regions, reduces increase of local resistance, and reduces heat accumulation. The uniform current distribution reduces the risk of hot spots caused by excessive local current.

The substrate 100 is configured to receive incident light and generate photogenerated carriers. In some embodiments, the substrate 100 can be a semiconductor substrate 100, for example, can be silicon, germanium, germanium-silicon, or silicon on an insulator.

In some embodiments, the substrate 100 can be made of an elemental semiconductor material. Specifically, the elemental semiconductor material includes a single element, for example, can be silicon, or germanium. The elemental semiconductor material can be in a single crystalline state, a polycrystalline state, an amorphous state, or a microcrystalline state (i.e., a state having both the single crystalline state and the amorphous state, referred to as microcrystalline state). For example, silicon can be at least one of monocrystalline silicon, polycrystalline silicon, amorphous silicon, and microcrystalline silicon. If the material of the substrate 100 is silicon, the material of the substrate 100 can include at least one of monocrystalline silicon, polycrystalline silicon, amorphous silicon, and microcrystalline silicon.

The substrate 100 can be an N-type semiconductor substrate 100, or a P-type semiconductor substrate 100. The N-type semiconductor substrate 100 is doped with an N-type doping element. The N-type doping element can be any one of Group V elements, such as phosphorus (P) element, bismuth (Bi) element, stibium (Sb) element, or arsenic (As) element. The P-type semiconductor substrate 100 is doped with a P-type doping element. The P-type doping element can be any one of Group III elements, such as boron (B) element, aluminum (Al) element, gallium (Ga) element, or indium (In) element.

The solar cell is a single-sided cell, and the front surface 110 of the substrate 100 serves as a light receiving surface for receiving incident light, and the back surface 120 of the substrate 100 serves as a backlight surface.

It can be understood that the first protruding portion 130, the second protruding portion 150, and the recessed portion 140 can have different heights from each other. The term "different height" herein means that the thickness of the substrate 100 at the position corresponding to the first protruding portion 130, the thickness of the substrate 100 at the position corresponding to the second protruding portion 150, and the thickness of the substrate 100 at the position corresponding to the recessed portion 140 are different from each other. The recessed portion 140 can isolate the first protruding portion 130 from the second protruding portion 150, thereby preventing a direct contact between the first protruding portion 130 and the second protruding portion 150, which prevents formation of additional recombination centers other than a PN junction, and thus prevents increase of carrier recombination and prevents reduce of cell efficiency. The recessed portion 140 can increase electrical isolation between the first protruding portion 130 and the second protruding portion 150, reducing generation of a leakage current.

In some embodiments, the recessed portion 140 can include a flat region 160, a transition region 170, and a textured region 180. The flat region 160 is adjacent to the first protruding portion 130, and the third doped layer 103 further covers a surface of the flat region 160. The transition region 170 is located on a side of the flat region 160 away from the first protruding portion 130. The textured region 180 is located on a side of the transition region 170 away from the flat region 160, and the textured region 180 has a morphology of a pyramid structure.

The flat region 160 corresponds to the portion of the first doped layer 101 protruding beyond the sidewall of the first protruding portion 130. During the formation of the third doped layer 103, due to the protection of the first doped layer 101, a portion of the third doped layer 103 located on the surface of the recessed portion 140 can be retained. Subsequently, during the formation of the textured region 180 in the recessed portion 140, the retained portion of the third doped layer 103 protects a portion of the recessed portion 140 from etching, thereby forming the flat region 160, the transition region 170, and the textured region 180.

The flat region 160 of the recessed portion 140 is configured to support a portion of the third doped layer 103. The transition region 170 is configured to form a transitional bridge between the flat region 160 and the textured region 180. The morphological difference between the flat region 160 and the textured region 180 can lead to concentration of mechanical stress. The transition region 170 can distribute the stress by gradually varying the surface morphology, thereby preventing cracks or damage to the solar cell at the interface due to stress concentration. The textured region 180 is configured to enhance a light reflection capability in the recessed portion 140 and reflect light incident on the back surface 120 back into the substrate 100, thereby improving the light absorption capability of the solar cell.

It should be noted that the flat region 160 herein is relatively flat relative to the textured region 180, which does not mean that the surface of the flat region 160 is absolutely flat.

In some embodiments, a width c of the flat region 160 ranges from 0.1 µm to 3 µm, such as 0.2 µm, 0.5 µm, 1 µm, 1.3 µm, 1.8 µm, 2.2 µm, 2.5 µm, or 2.9 µm, etc. The flat region 160 supports the third doped layer 103. For the width of the flat region 160, if the width of the flat region 160 is less than 0.1 µm, manufacturing the solar cell has increased difficulty, the third doped layer 103 as a current leakage structure has poor performance, and thus the capability of mitigating the hot spot phenomenon fails to meet expectation. If the width of the flat region 160 is greater than 3 µm, excessive leakage current is likely generated by the third doped layer 103, affecting photoelectric conversion efficiency of the solar cell. Moreover, if the flat region 160 is excessively wide, during the formation of the third doped layer 103, the first doped layer 101 cannot protect the third doped layer 103 well, resulting in uneven distribution of the current leakage path on the third doped layer 103, which can lead to localized current concentration and increase the risk of hot spots.

In some embodiments, a height e of the transition region 170 ranges from 0.5 µm to 3 µm, such as 0.8 µm, 1 µm, 1.3 µm, 1.5 µm, 1.7 µm, 2 µm, 2.3 µm, or 2.8 µm, etc. It can be understood that, if the height of the transition region 170 is less than 0.5 µm, light cannot be effectively guided from the flat region 160 to the textured region 180, which can lead to increased light reflection loss at the interface. Moreover, if the height of the transition region 170 is less than 0.5 µm, it means that a pyramid morphology size of the textured region 180 is excessively small, which can result in a poor light-trapping capability of the textured region 180. If the height of the transition region 170 is greater than 3 µm, a pyramid-like structure can be formed on the surface of the transition region 170, which competes with the structure of the textured region 180, reducing overall light-trapping efficiency.

In some embodiments, an inclination angle of the transition region 170 can range from 30° to 60°, such as 35°, 40°, 45°, 53°, 57°, or 58°, etc. It can be understood that, if the inclination angle of the transition region 170 is less than 30°, specular reflection of light can occur in the transition region 170, which reduces the light absorption capability of the solar cell. If the inclination angle of the transition region 170 is greater than 60°, the light may be reflected to the surface of the solar cell, resulting in light loss. On the other hand, due to influences of crystal orientation and crystal plane of the material of the substrate 100, the inclination angle of the transition region 170 can approach a range from 30° to 60° during the formation of the transition region 170. Maintaining the inclination angle of the transition region 170 to be 30° to 60° ensures that the inclination angle is consistent with the high mobility direction of carriers in the (100) crystal orientation, thereby reducing recombination loss.

It should be noted that the inclination angle herein refers to an angle between a normal direction of the surface of the transition region 170 and a normal direction of the surface of the flat region 160.

It can be understood that the height and the inclination angle of the transition region 170 can be designed in a coordinated manner. The height and the inclination angle together determine distribution of photogenerated carriers and collection efficiency thereof. For example, the height of the transition region 170 is set to be 2 µm, and the inclination angle is set to be 45°, which can balance light absorption and carrier transport path.

In some embodiments, a width d of the textured region 180 can range from 20 µm to 200 µm, such as 30 µm, 40 µm, 50 µm, 60 µm, 80 µm, 100 µm, 130 µm, 160 µm, or 190 µm. For the textured region 180, the wider the textured region 180, the greater the light-trapping capability; whereas the smaller the width of the textured region 180, the worse the capability of reflecting light back into the substrate 100 for absorption.

If the width of the textured region 180 is less than 20 µm, there can be an insufficient number of pyramid structures in the textured region 180, leading to a limited light-trapping effect and increased light reflection loss. If the width of the textured region 180 is greater than 200 µm, the pyramid structures are excessively dense, which can increase energy loss of light due to multiple light reflections, thereby reducing light absorption efficiency.

In some embodiments, a height of the pyramid structure in the textured region 180 ranges from 1 µm to 3 µm, a length of a base edge of the pyramid structure ranges from 0.1 µm to 2 µm, a specific surface area of the pyramid structure ranges from 1.1 to 2, a reflectivity of the pyramid structure ranges from 7% to 15%, and a density of the pyramid structure ranges from 100000 per mm² to 400000 per mm².

For the height of the pyramid structure, if the height of the pyramid structures is less than 1 µm, the textured region 180 has a limited light-trapping effect, high reflectivity, and low light absorption efficiency. If the height of the pyramid structures is greater than 3 µm, the light can undergo multiple reflections in the textured region 180, and energy loss of light increases due to the multiple light reflections, leading to a decrease in the light absorption efficiency.

For the length of the base edge of the pyramid structure, if the length of the base edge of the pyramid structure is less than 0.1 µm, the pyramid structure is excessively small, which can lead to insufficient light scattering and high reflectivity. If the length of the base edge of the pyramid structure is greater than 2 µm, the pyramid structure is excessively large, and the reflection path of light between the pyramid structures is excessively long, resulting in increase of energy loss.

For the specific surface area of the pyramid structure, if the specific surface area is less than 1.1, the textured region 180 has an insufficient light absorption area, leading to high reflectivity. If the specific surface area is greater than 2, the pyramid structure may be excessively dense, resulting in increase of light scattering loss.

It can be understood that the specific surface area refers to a ratio of surface areas of the pyramid structures to a surface area of the textured region 180.

For the reflectivity of the pyramid structure, when the reflectivity is greater than 15%, it results in significant light loss and reduced cell efficiency. When the reflectivity is less than 7%, a complex anti-reflection coating or structure may be required, thereby increasing costs.

For the density of the pyramid structure, the pyramid density less than 100000 per mm² can result in insufficient density of the pyramid structure, leading to high light reflection loss; whereas the pyramid density greater than 400000 per mm² can cause the pyramid structure to be too dense, resulting in increase of light scattering loss.

In some embodiments, a height difference b between a bottom surface of the first protruding portion 130 and a bottom surface of the flat region 160 ranges from 1 µm to 5 µm, such as 2 µm, 3 µm, or 4 µm, etc. The height difference between the bottom surface of the first protruding portion 130 and the bottom surface of the flat region 160 is set to be ≥1 µm, which ensures sufficient physical isolation between the first protruding portion 130 and the second protruding portion 150, preventing recombination loss of carries due to path crossing during the carrier transport. The height difference between the bottom surface of the first protruding portion 130 and the bottom surface of the flat region is set to be ≤5µm, which prevents an increase in the carrier transport distance in the substrate 100, thereby preventing an increase in series resistance.

In some embodiments, the solar cell further includes a front passivation layer (not shown). The front passivation layer is located on the front surface 110. The front passivation layer can have a single-layer structure or a laminated structure.

In some embodiments, the solar cell further includes a first tunneling layer 106 disposed between the first doped layer 101 and the substrate 100. The first tunneling layer 106 can be made of silicon oxide, silicon nitride, silicon oxynitride, or the like. The first tunneling layer 106 is configured to not only passivate the substrate 100, but also does not affect the transport of carriers and can buffer interfacial tension between the substrate 100 and the first doped layer 101, thereby reducing loss during carrier transport.

In some embodiments, a thickness of the first tunneling layer 106 ranges from 0.5 nm to 2 nm.

The first doped layer 101 can be made of doped polysilicon. The doped polysilicon has good electrical conductivity, and can effectively transport carriers. Moreover, the doped polysilicon has a good ohmic contact with the subsequently formed first electrode 104, thereby reducing contact resistance between the first electrode 104 and the first doped layer 101.

In some embodiments, the first doped layer 101 protrudes beyond the sidewall of the first protruding portion 130 by a distance a ranging from 0.1 µm to 3 µm. A portion of the first doped layer 101 protruding beyond the sidewall of the first protruding portion 130 is a contact window between the first doped layer 101 and the third doped layer 103. If the distance by which the first doped layer 101 protrudes beyond the sidewall of the first protruding portion 130 is less than 0.1 µm, a contact area between the first doped layer 101 and the third doped layer 103 is reduced, thereby weakening the leakage current effect and increasing the difficulty of forming the third doped layer 103. If the distance by which the first doped layer 101 protrudes beyond the sidewall of the first protruding portion 130 is greater than 3 µm, a process waste is caused, and a spacing between the third doped layer 103 and the second doped layer 102 is reduced, likely leading to connection between the third doped layer 103 and the second doped layer 102.

In some embodiments, a thickness of the first doped layer 101 ranges from 30 nm to 300 nm, such as 40 nm, 60 nm, 80 nm, 100 nm, 150 nm, 180 nm, 190 nm, 210 nm, 240 nm, 260 nm, or 280 nm, etc. The thickness of the first doped conductive layer is set to be ≥30 nm, which ensures that sufficient dopant atoms form a continuous conductive path, thereby reducing lateral resistance and series resistance. If the thickness of the first doped layer 101 is set to be greater than 300 nm, the carrier transport distance is increased, increasing the probability of recombination, which in turn reduces a fill factor of the solar cell.

In some embodiments, the solar cell further includes a second tunneling layer 107 disposed between the second doped layer 102 and the substrate 100. A material of the second tunneling layer 107 can be the same as that of the first tunneling layer 106, such as silicon oxide, silicon nitride, or silicon oxynitride, etc., which can reduce the number of material types in the solar cell, reduce the number of processes required to form the solar cell, and decrease the difficulty of forming the solar cell. The material of the second tunneling layer 107 can alternatively be intrinsic amorphous silicon. The intrinsic amorphous silicon has excellent surface passivation property, which can significantly reduce carrier recombination on the back surface. Moreover, by using hydrogen atoms in the intrinsic amorphous silicon to passivate dangling bonds, surface state density is reduced, thereby reducing recombination and improving the open-circuit voltage and the fill factor.

The material of the second doped layer 102 can be the same as that of the first doped layer 101, which can also reduce the number of material types in the solar cell, reduce the number of processes required to form the solar cell, and decrease the difficulty of forming the solar cell. The material of the second doped layer 102 can alternatively be doped amorphous silicon.

When the second tunneling layer 107 is made of intrinsic amorphous silicon, the material of the second doped layer 102 is doped amorphous silicon. When the second tunneling layer 107 is made of silicon oxide, silicon nitride, or silicon oxynitride, the material of the second doped layer 102 is doped polycrystalline silicon.

In some embodiments, the solar cell further includes a third tunneling layer 108 disposed between the third doped layer 103 and the substrate 100. A material of the third tunneling layer 108 can be the same as that of the second tunneling layer 107. In this way, the third tunneling layer 108 and the second tunneling layer 107 can be formed in the same process step, which reduces the number of process steps for forming the solar cell.

The third doped layer 103 is made of the same material as the second doped layer 102. Similarly, the third tunneling layer 108 and the second tunneling layer 107 can be formed in the same process step, and then the third tunneling layer 108 and the second tunneling layer 107 are isolated through other process steps.

In some embodiments, the third doped layer 103 leaves the transition region 170 exposed. That is, the third doped layer 103 does not cover the surface of the transition region 170. On the one hand, the formation of the transition region 170 is prevented from being affected by the third doped layer 103. On the other hand, the main function of the transition region 170 is to smoothen the electric field distribution and the carrier transport path, rather than to directly participate in current collection. If the third doped layer 103 covers the transition region 170, additional resistance or recombination centers may be introduced, interfering with transport of carriers from the textured region 180 to the flat region 160.

In some embodiments, a concentration of doping elements in the third doped layer 103 is the same as that of doping elements in the second doped layer 102. That is, the third doped layer 103 and the second doped layer 102 can be doped in the same process step, thereby reducing the number of process steps for forming the solar cell and decreasing the cost for manufacturing the solar cell.

In some embodiments, the first doped layer 101 protrudes beyond two sides of the first protruding portion 130, and the third doped layer 103 covers both opposite sidewalls of the first protruding portion 130. In other words, the third doped layer 103 is disposed on each side of the first protruding portion 130. That is, the current leakage structures are formed on the two sides of the first protruding portion 130, thereby increasing the current leakage effect of the third doped layer 103 and further mitigating the hot spot phenomenon of the solar cell.

In some embodiments, the third doped layer 103 covers the sidewall of the first protruding portion 130 along a first direction, and the second doped layer 102 is in contact with a sidewall of the first doped layer 101 along a second direction. That is, the first protruding portion 130 is provided with the third doped layer 103 on the sidewall thereof along the first direction for current leakage, and also the second doped layer 102 is in direct contact with the first doped layer 101 along the second direction to cause current leakage. In this way, the current leakage effect can be transferred to the entire solar cell, thereby reducing the destructive impact of local hot spot phenomenon on the solar cell.

In the above embodiments, the second direction refers to a direction in which the first protruding portion 130 and the second protruding portion 150 are arranged alternately. That is, the second direction is an M-M1 direction shown in FIG. 2. The first direction refers to a direction perpendicular to the second direction. That is, the first direction is an N-N1 direction perpendicular to the M-M1 direction shown in FIG. 2. As shown in FIG. 2, R1 represents a region where the third doped layer covers a sidewall of the first protruding portion in the first direction. R2 represents a region where the second doped layer is in contact with a sidewall of the first doped layer in the second direction. It should be noted that since FIG. 2 is a partial view of the solar cell of the present application, the region represented by R1 in FIG. 2 can include the region which can be seen in FIG. 2 and a region not shown in FIG. 2.

It can be understood that, in existing methods for forming solar cells, an etching process is typically performed between the first doped layer 101 and the second doped layer 102 to separate the first doped layer 101 and the second doped layer 102. In the related art, a residue material is generally controlled to exist at a boundary between the first doped layer 101 and the second doped layer 102 to form local leakage current; and in some cases, the process for forming the local current leakage which is not well controlled can cause damage to the substrate during the formation of the local leakage current. In the embodiments of the present application, by arranging the third doped layer 103 while controlling the sidewalls of the first doped layer 101 and the second doped layer 102 along the second direction to be in contact, the leakage current can be transferred to the entire cell surface, thereby transforming the hot spot phenomena from a point to a surface, and reducing local destructive damage.

In some embodiments, a width of a contact interface between the third doped layer 103 and the first doped layer 101 ranges from 0.1 µm to 2 µm, such as 0.2 µm, 0.5 µm, 0.7 µm, 0.8 µm, 1 µm, 1.3 µm, 1.5 µm, 1.6 µm, or 1.9 µm, etc. For the third doped layer 103, the wider the contact interface between the third doped layer 103 and the first doped layer 101, the better the current leakage effect. However, excessive leakage current between the third doped layer 103 and the first doped layer 101 can affect the photoelectric conversion efficiency of the solar cell.

In some embodiments, the solar cell further includes a fourth doped layer. The fourth doped layer covers a sidewall of the second protruding portion 150 and a portion of a surface of the recessed portion 140, the fourth doped layer is in contact with and electrically connected to the second doped layer 102, and the fourth doped layer is doped with an element of a first doping type. In other words, a current leakage layer is also disposed on the sidewall of the second protruding portion 150. Similar to the third doped layer 103, the fourth doped layer is also configured for current leakage. Different from the third doped layer 103, a type of doping elements in the fourth doped layer differs from that of doping elements in the third doped layer 103.

It should be noted that the fourth doped layer can differ from the third doped layer 103 only in the type of doping elements, and the remaining parts can be referenced to the foregoing description of the third doped layer 103, which is not described in detail herein again. Similarly, a positional relationship between the fourth doped layer and the second doped layer 102 can also be referenced to the relationship between the first doped layer 101 and the third doped layer 103, which is not described in detail herein again.

Embodiments of the present application provide a solar cell. The first doped layer 101 is disposed to protrude beyond the sidewall of the first protruding portion 130, and the protruding part of the first doped layer 101 is taken as a contact window to be contact with the third doped layer 103, thereby forming a current leakage path between the first doped layer 101 and the third doped layer 103. When the solar cell is partially shaded or the solar cell malfunctions to cause abnormal local heating, the current leakage path can shunt the electric current, thereby mitigating influences of the hot spot phenomenon. Besides, the first doped layer 101 is disposed to protrude beyond the sidewall of the first protruding portion 130, which can protect the third doped layer 103 located below the first doped layer 101, thereby facilitating retaining of the third doped layer 103 located below the first doped layer 101 to establish a good current leakage path. Moreover, during the formation of the third doped layer 103, since the first doped layer 101 is disposed to protrude beyond the sidewall of the first protruding portion 130, the surface of the third doped layer 103 can be protected from erosion by an etching reagent, so as to establish a relatively complete current leakage channel on the back surface 120 of the solar cell. The complete current leakage channel can provide a uniform transport path for charge carriers, which prevents concentration of the current in certain regions, reduces increase of local resistance, and reduces heat accumulation. The uniform current distribution reduces the risk of hot spots caused by excessive local current.

Embodiments of the present application further provide a manufacturing method for a solar cell. The manufacturing method can be used to form the solar cells in some or all of the foregoing embodiments. The method for manufacturing the solar cell provided in another embodiment of the present application will be described below with reference to the accompanying drawings. It should be noted that parts identical or corresponding to those in the foregoing embodiments can be referenced to the corresponding description in the foregoing embodiments, which will not be described in detail below.

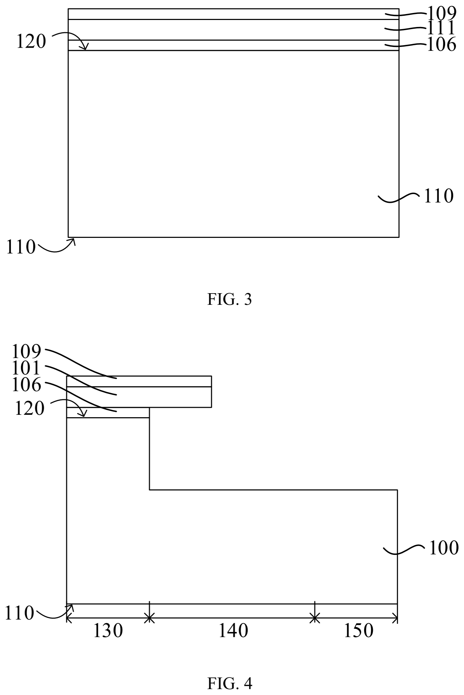

Referring to FIG. 3 to FIG. 5 and FIG. 1, schematic structural views corresponding to steps of the manufacturing method for a solar cell according to an embodiment of the present application are shown.

In some embodiments, the method for manufacturing the solar cell includes providing an initial substrate 110, wherein the initial substrate 110 includes a front surface 110 and a back surface 120 opposite to each other.

The method for manufacturing the solar cell further includes forming an initial first doped layer 111, wherein the initial first doped layer 111 covers the back surface 120 of the initial substrate 110.

The method for manufacturing the solar cell further includes performing an alkaline polishing process, wherein the alkaline polishing process includes etching the initial first doped layer 111 and the initial substrate 110 to form the first protruding portion 130, the second protruding portion 150, and the recessed portion 140 located between the first protruding portion 130 and the second protruding portion 150 that are arranged alternately, with the remaining initial substrate 110 as the substrate 100, and forming a plurality of first doped layers 101 arranged at intervals, the first doped layer 101 covers a surface of the first protruding portion 130 away from the front surface 110, the first doped layer 101 protrudes beyond a sidewall of the first protruding portion 130, and the first doped layer 101 is doped with an element of a first doping type.

The method for manufacturing the solar cell further includes forming a plurality of second doped layers 102 arranged at intervals, wherein the second doped layer 102 covers a bottom surface of the second protruding portion 150, and the second doped layer 102 is doped with an element of a second doping type.

The method for manufacturing the solar cell further includes forming a third doped layer 103, wherein the third doped layer 103 covers at least the sidewall of the first protruding portion 130, the third doped layer 103 is in contact with a portion of the first doped layer 101 protruding beyond the sidewall of the first protruding portion 130, the third doped layer 103 is doped with an element of a second doping type, the element of the first doping type is either of N-type element and P-type element, and the element of the second doping type is the other of the N-type element and the P-type element.

The method for manufacturing the solar cell further includes forming a first electrode 104, wherein the first electrode 104 is electrically connected to the first doped layer 101.

The method for manufacturing the solar cell further includes forming a second electrode 105, wherein the second electrode 105 is electrically connected to the second doped layer 102.

Through forming the third doped layer 103 and making the third doped layer 103 to be in contact with the first doped layer 101, a current leakage structure is formed. When a hot spot occurs, the current leakage structure shunts the electric current, thereby mitigating negative effects caused by the hot spot phenomenon. Moreover, during the formation of the first doped layer 101, the first doped layer 101 formed further protrudes beyond the sidewall of the first protruding portion 130, and thus the first doped layer 101 serves as a mask during the subsequent formation of the third doped layer 103, thereby preventing removal of the first doped layer 101 located on the sidewall of the first protruding portion 130, reducing process steps of forming a mask layer, and decreasing the cost of manufacturing the solar cell.

Referring to FIG. 3, an initial substrate 110 is provided, and an initial first doped layer 111 is formed.

In some embodiments, prior to forming the initial first doped layer 111, the method further includes forming a first tunneling layer 106, wherein the first tunneling layer 106 covers a surface of the initial substrate 110.

The method for forming the initial first doped layer 111 includes forming a polysilicon layer by a deposition process, and converting the polysilicon layer into the initial first doped layer 111 by a diffusion process, wherein a first glass layer 109 is formed during the conversion of the polysilicon layer into the initial first doped layer 111.

In some embodiments, prior to forming the first tunneling layer 106, the method further includes forming a front passivation layer (not shown) on the front surface 110 of the substrate 100.

Referring to FIG. 4, a substrate 100 and a first doped layer 111 are formed.

In some embodiments, the alkaline polishing process includes performing a laser treatment by irradiating a surface of the initial first doped layer 111; and performing a wet etching process, including removing the initial first doped layer 111 that has undergone the laser treatment, and etching a portion of the initial substrate 110 to form the first doped layer 101 and the substrate 100. Through the laser treatment, a portion of the initial first doped layer 111 can be modified to change the etch selectivity of the portion of the initial first doped layer 111, which facilitates removal of the initial first doped layer 111 by wet etching. Through the wet etching process, the first doped layer 101 and the substrate 100 can be formed.

In some embodiments, during the formation of the initial first doped layer 111, the first glass layer 109 is further formed. Through the laser treatment, the surface of the first glass layer 109 is irradiated to modify a portion of the first glass layer 109. Other portions of the first glass layer 109 which are not irradiated by the laser serve as a protective layer in the wet etching process, which can prevent portion of the initial first doped layer 111 from etching, thereby forming the first doped layer 101 with desired morphology without forming a mask layer.

In some embodiments, a thickness of the initial first doped layer 111 ranges from 30 nm to 500 nm, and a thickness of the first glass layer 109 ranges from 20 nm to 100 nm.

In some embodiments, the wet etching process further includes etching the substrate 100. It can be understood that the wet etching process can generate both vertical etching and lateral etching. Consequently, when the substrate 100 is etched, the first doped layer 101 can protrude beyond the formed first protruding portion 130.

Process parameters of the laser treatment include a laser type of an infrared light source, a green light source, or an ultraviolet light source; laser energy ranging from 50 W to 150 W; a scan speed ranging from 10 m/s to 100 m/s; and a frequency ranging from 500 kHz to 1500 kHz. The laser type of the laser treatment can be determined by balancing the thickness of the first glass layer 109, precision of required opening, and tolerance for thermal damage. An infrared light source, a green light source, or an ultraviolet light source can meet requirements for precision and damage. The laser energy is required to modify the first glass layer 109 to facilitate subsequent etching. Therefore, the laser energy is set to range from 50 W to 150 W. The scan speed is coordinated with the laser energy to ensure that each pulse has sufficient energy density. If the frequency is excessively low, the laser treatment is discontinuous, resulting in abnormal morphology. If the frequency is excessively high, overheating can be caused during the laser treatment.

Process parameters of the wet etching process include an etching time period ranging from 100 s to 500 s, a temperature ranging from 60 °C to 80 °C, and an alkaline etching additive as an additive and with an addition amount ranging from 0.5 L to 50 L.

It can be understood that, through this step, the first protruding portion 130 is formed, while no distinct boundary is formed between the second protruding portion 150 and the recessed portion 140.

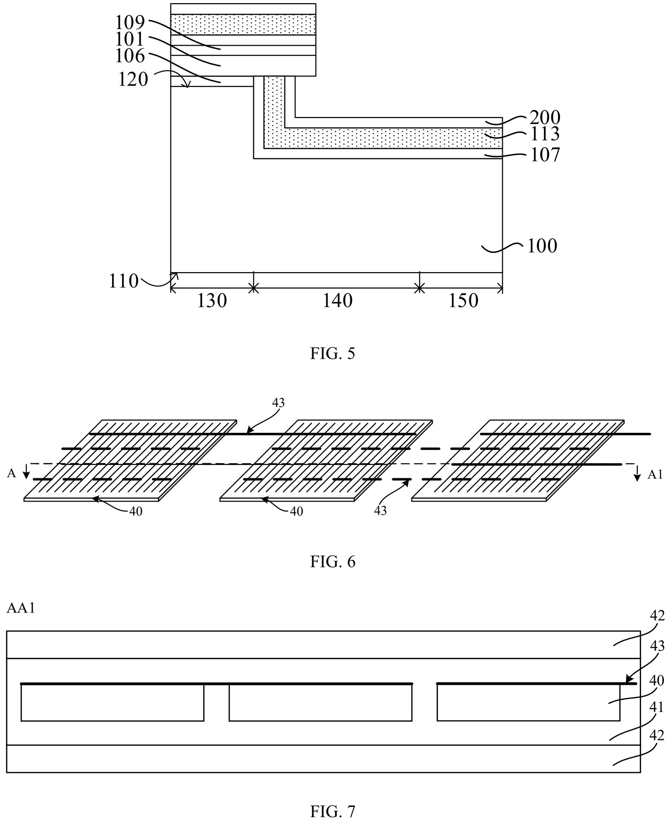

Referring to FIG. 5 and FIG. 1, a second doped layer 102 and a third doped layer 103 are formed.

Referring to FIG. 5, in some embodiments, prior to forming an initial third doped layer 113, a second tunneling layer 107 is formed, wherein the second tunneling layer 107 covers the first doped layer 101 and the back surface 120 of the substrate 100. In some other embodiments, the first glass layer 109 is not removed, and the second tunneling layer 107 covers the surface of the first glass layer 109.

The initial third doped layer 113 is formed, and the initial third doped layer 113 covers the first doped layer 101 and the back surface 120 of the substrate 100. It can be understood that the method for forming the initial third doped layer 113 includes first depositing a polysilicon layer on the entire surface, and then doping the polysilicon layer to form the initial third doped layer 113. During the formation of the initial third doped layer 113, a second glass layer 200 is formed.

Subsequently, a laser processing is performed. During the laser processing, a portion of the initial third doped layer 113 is removed along a direction from the back surface 120 towards the front surface 110, while the remaining initial third doped layer 113 located on the sidewall of the first protruding portion 130 serves as the third doped layer 103.

The laser processing can include laser irradiation. It can be understood that the second glass layer 200 is formed during the formation of the initial third doped layer 113, and the second glass layer 200 hinders subsequent etching process. Therefore, the second glass layer 200 is modified by laser irradiation to facilitate subsequent etching. Subsequently, a wet etching is performed. The wet etching process includes etching portions of the second glass layer 200, the initial third doped layer 113, and the second tunneling layer 107, while the remaining portions of the initial third doped layer 113 and the second tunneling layer 107 located on the sidewall of the first protruding portion 130 serve as the third doped layer 103 and the third tunneling layer 108, and the remaining portions of the initial third doped layer 113 and the second tunneling layer 107 located on the surface of the second protruding portion 150 serve as the second doped layer 102 and the second tunneling layer 107.

It can be understood that, since the first doped layer 101 protrudes beyond the sidewall of the first protruding portion 130, the second glass layer 200 located below the first doped layer 101 is not irradiated, while the second glass layer 200 on the surface of the second protruding portion 150 is selectively not irradiated. Consequently, during the subsequent wet etching, the unirradiated second glass layer 200 serves as a mask, protecting the initial third doped layer 113 and the second tunneling layer 107 to form the third doped layer 103, the third tunneling layer 108, the second doped layer 102, and the second tunneling layer 107.

In some embodiments, process parameters of the laser processing include a laser type of an infrared light source, a green light source, or an ultraviolet light source; laser energy ranging from 50 W to 150 W; a scan speed ranging from 10 m/s to 100 m/s; and a frequency ranging from 500 kHz to 1500 kHz.

Referring to FIG. 1, a texturing process is performed. The texturing process includes removing the first glass layer 109 and the second glass layer 200, and the texturing process further includes forming a transition region 170 and a textured region 180 on the recessed portion 140.

Subsequently, a first electrode 104 and a second electrode 105 are formed by screen printing.

Yet another embodiment of the present application provides a photovoltaic module. The photovoltaic module includes the solar cell in some or all of the foregoing embodiments or the solar cell formed with the manufacturing method for the solar cell in some or all of the foregoing embodiments. It should be noted that the contents identical or corresponding to the foregoing embodiments can be referenced to the foregoing embodiments, which will not be described in detail below again.

Referring to FIG. 6 and FIG. 7, FIG. 6 is a partial schematic three-dimensional view of a photovoltaic module according to another embodiment of the present application, and FIG. 7 is a partial schematic cross-sectional view of FIG. 6 taken along a first cross-section direction AA1.

In some embodiments, the photovoltaic module includes a solar cell string including a plurality of solar cells 40 in some or all of the foregoing embodiments or a plurality of solar cells 40 manufactured with the method for manufacturing the solar cell in some or all of the foregoing embodiments; and a solder strip 43 electrically connected to at least two solar cells 40 to connect adjacent solar cells 40 in series.

The photovoltaic module further includes an encapsulation adhesive film 41, wherein the encapsulation adhesive film 41 is configured to cover a surface of the solar cell string.

The photovoltaic module further includes a cover plate 42, wherein the cover plate 42 is configured to cover a surface of the encapsulation adhesive film 41 away from the solar cell string.

In some embodiments, the encapsulation adhesive film 41 includes a first encapsulation layer and a second encapsulation layer. The first encapsulation layer covers either of the front surface and the back surface of the solar cell, and the second encapsulation layer covers the other of the front surface and the back surface of the solar cell. Specifically, at least one of the first encapsulation layer and the second encapsulation layer can be an organic encapsulation adhesive film such as a polyvinyl butyral (PVB) adhesive film, an ethylene-vinyl acetate copolymer (EVA) adhesive film, a polyolefin elastomer (POE) adhesive film, or a polyethylene glycol terephthalate (PET) adhesive film. Alternatively, at least one of the first encapsulation layer and the second encapsulation layer can be an adhesive film such as an EP adhesive film, an EPE adhesive film, or a PVP adhesive film. The EP adhesive film refers to a co-extruded adhesive film formed by an EVA adhesive film and a POE adhesive film that are laminated. The EPE adhesive film refers to a co-extruded adhesive film formed by an EVA adhesive film, a POE adhesive film, and an EVA adhesive film that are sequentially laminated. The PVP adhesive film refers to a co-extruded adhesive film formed by a POE adhesive film, an EVA adhesive film, and a POE adhesive film that are sequentially laminated. The co-extruded adhesive film can be prepared by extruding one or more raw materials sequentially onto another prepared adhesive film or by laminating different types of prepared adhesive films together during adhesive film processing.

In some embodiments, there is a boundary between the first encapsulation layer and the second encapsulation layer before lamination, and after lamination to form the photovoltaic module, the concept of the first encapsulation layer and the second encapsulation layer does not exist. That is, the first encapsulation layer and the second encapsulation layer have formed the entire encapsulation adhesive film 41.

In some embodiments, the cover plate 42 can be a cover plate with a light-transmitting function such as a glass cover plate or a plastic cover plate. Specifically, a surface of the cover plate 42 facing the encapsulation adhesive film 41 can be an uneven surface or a textured surface including a plurality of protruding structures, so as to increase utilization of incident light. The cover plate 42 includes a first cover plate and a second cover plate. The first cover plate is opposite to the first encapsulation layer. The second cover plate is opposite to the second encapsulation layer.

Those of ordinary skill in the art can understand that the above implementations are specific embodiments for implementing the present application, and in practical applications, various changes can be made in form and details without departing from the spirit and scope of the embodiments of the present application. It should be understood by those of ordinary skill in the art that various modifications and improvements can be made without departing from the concept of the present application, and all fall within the protection scope of the present application. Therefore, the protection scope of the present application should be subject to the appended claims.

## Claims

1. A solar cell, comprising:
a substrate comprising a front surface and a back surface opposite to each other, the back surface provided with a first protruding portion, a second protruding portion, and a recessed portion located between the first protruding portion and the second protruding portion that are arranged alternately;
a plurality of first doped layers arranged at intervals, the first doped layer covering a surface of the first protruding portion away from the front surface, the first doped layer protruding beyond a sidewall of the first protruding portion, and the first doped layer doped with an element of a first doping type;
a plurality of second doped layers arranged at intervals, the second doped layer covering a bottom surface of the second protruding portion, and the second doped layer doped with an element of a second doping type;
a third doped layer, the third doped layer covering at least the sidewall of the first protruding portion, the third doped layer being in contact with a portion of the first doped layer protruding beyond the sidewall of the first protruding portion, the third doped layer doped with an element of the second doping type, the element of the first doping type being either of N-type element and P-type element, and the element of the second doping type being another of the N-type element and the P-type element;
a first electrode electrically connected to the first doped layer; and
a second electrode electrically connected to the second doped layer.

2. The solar cell according to claim 1, wherein the recessed portion comprises a flat region, a transition region, and a textured region;
the flat region is adjacent to the first protruding portion, and the third doped layer further covers a surface of the flat region;
the transition region is located on a side of the flat region away from the first protruding portion; and
the textured region is located on a side of the transition region away from the flat region, and the textured region has a morphology of a pyramid structure.

3. The solar cell according to claim 2, wherein the third doped layer leaves the transition region exposed.

4. The solar cell according to claim 2, wherein a height of the transition region ranges from 0.5 µm to 3 µm, and an inclination angle of the transition region ranges from 30° to 60°.

5. The solar cell according to any one of claims 1 to 4, wherein a concentration of doping elements in the third doped layer is the same as a concentration of doping elements in the second doped layer.

6. The solar cell according to any one of claims 1 to 5, wherein the first doped layer is disposed to protrude beyond two sides of the first protruding portion, and the third doped layer covers the two sidewalls of the first protruding portion opposite to each other.

7. The solar cell according to any one of claims 1 to 6, further comprising a fourth doped layer, wherein the fourth doped layer covers a sidewall of the second protruding portion and a portion of a surface of the recessed portion, the fourth doped layer is in contact with and electrically connected to the second doped layer, and the fourth doped layer is doped with an element of the first doping type.

8. The solar cell according to any one of claims 1 to 7, wherein the third doped layer covers a sidewall of the first protruding portion along a first direction, and the second doped layer is in contact with a sidewall of the first doped layer along a second direction.

9. The solar cell according to any one of claims 1 to 8, wherein the first doped layer is disposed to protrude beyond the sidewall of the first protruding portion by a distance ranging from 0.1 µm to 3 µm.

10. The solar cell according to any one of claims 1 to 9, wherein a width of a contact interface between the third doped layer and the first doped layer ranges from 0.1 µm to 2 µm.

11. A method for manufacturing the solar cell according to any one of claims 1 to 10, comprising:
providing an initial substrate, the initial substrate comprising a front surface and a back surface opposite to each other;
forming an initial first doped layer, the initial first doped layer covering the back surface of the initial substrate;
performing an alkaline polishing process, the alkaline polishing process etching the initial first doped layer and the initial substrate to form a first protruding portion, a second protruding portion, and a recessed portion located between the first protruding portion and the second protruding portion that are arranged alternately on the back surface, with the remaining initial substrate as a substrate, and forming a plurality of first doped layers arranged at intervals, the first doped layer covering a surface of the first protruding portion away from the front surface, the first doped layer protruding beyond a sidewall of the first protruding portion, and the first doped layer doped with an element of a first doping type;
forming a plurality of second doped layers arranged at intervals, the second doped layer covering a bottom surface of the second protruding portion, and the second doped layer doped with an element of a second doping type;
forming a third doped layer, the third doped layer covering at least the sidewall of the first protruding portion, the third doped layer being in contact with a portion of the first doped layer protruding beyond the sidewall of the first protruding portion, the third doped layer doped with an element of the second doping type, the element of the first doping type being either of N-type element and P-type element, and the element of the second doping type being another of the N-type element and the P-type element;
forming a first electrode electrically connected to the first doped layer; and
forming a second electrode electrically connected to the second doped layer.

12. The method according to claim 11, wherein the alkaline polishing process comprises:
a laser treatment by irradiating a surface of the initial first doped layer; and
a wet etching process, comprising removing the initial first doped layer that has undergone the laser treatment, and etching a portion of the initial substrate to form the first doped layer and the substrate.

13. The method according to claim 12, wherein process parameters of the laser treatment comprise: a laser type of an infrared light source, a green light source, or an ultraviolet light source, laser energy ranging from 50 W to 150 W, a scan speed ranging from 10 m/s to 100 m/s, and a frequency ranging from 500 kHz to 1500 kHz.

14. The method according to any one of claims 11 to 13, wherein a method for forming the third doped layer comprises:
forming an initial third doped layer, the initial third doped layer covering the first doped layer and a back surface of the substrate; and
performing laser processing, the laser processing comprising removing a portion of the initial third doped layer along a direction from the back surface towards the front surface, with the remaining initial third doped layer located on the sidewall of the first protruding portion as the third doped layer.

15. A photovoltaic module, comprising:
a solar cell string comprising a plurality of solar cells according to any one of claims 1 to 10 or a plurality of solar cells manufactured with the method according to any one of claims 11 to 14;
a solder strip electrically connected to at least two of the solar cells to connect adjacent solar cells in series;
an encapsulation adhesive film configured to cover a surface of the solar cell string; and
a cover plate configured to cover a surface of the encapsulation adhesive film away from the solar cell string.
